(19)

Europäisches
Patentamt
European
Patent Office
Office européen
des brevets

(11) **EP 1 914 882 A1**

(12) **EUROPEAN PATENT APPLICATION**

(43) Date of publication:
**23.04.2008 Bulletin 2008/17**

(51) Int Cl.:
*H03C 1/06* (2006.01)        *H03D 1/06* (2006.01)

(21) Application number: **07253981.0**

(22) Date of filing: **09.10.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **11.10.2006 GB 0620159**

(71) Applicant: **Tandberg Television ASA
0607 Oslo (NO)**

(72) Inventor: **Curtis, John S.
Eastleigh
Hampshire SO50 5HB (GB)**

(74) Representative: **Want, Clifford James
Harrison Goddard Foote
40-43 Chancery Lane
London WC2A 1JA (GB)**

(54) **Cancelling distortion**

(57)    A pre-distortion stage 50 is arranged to cancel a harmonic or intermodulation signal produced from an input signal. The pre-distortion stage includes non-amplifying components comprising a first distortion generator network 51 arranged to produce an in-phase distorted version of the input signal and a second harmonic generator network 52 arranged to produce an in-quadrature distorted version of the input signal. Outputs of the first and second distortion generator networks are combined to produce a combined distortion signal the amplitude and phase of which can be independently adjusted to be of a same amplitude and frequency as, but 180 deg. out of phase with, the harmonic or intermodulation signal generated from the input signal, so as to cancel the harmonic or intermodulation signal. The pre-distortion stage has particular application in cancelling spurs generated in a mixer when the spurs are too close in frequency to a required signal to be efficiently removed by filtering.

Figure 5

**EP 1 914 882 A1**

**Description**

This invention relates to cancelling distortion and in particular to reducing spurs in a mixer output.

A known mixer or modulator is a device for shifting a signal from one frequency band to another. A mixer typically uses a multiplication process wherein a wanted variable signal of frequency R, occupying a band of spectrum, and a locally generated single frequency oscillator signal of frequency L, are combined to form sum and difference signals at frequencies R+L and -R+L; a convenient one of these is taken for further processing and the other is removed, typically by filtering. In practical implementations it is usual for such multiplication process to be realised by a non-linearity which also leads to a number of other, unwanted, combinations of R and L, for example, a term formed by a second harmonic of R and L i.e. 2R±L. In most practical implementations these spurious products of the multiplication, known as "spurs", are also filtered away to a degree that reduces their harmful effects to tolerable levels. Occasionally circumstances, to be described later herein, arise that make this filtering process difficult, or even make it impossible to achieve a required degree of suppression. In this case, alternative means of dealing with spurious products are necessary.

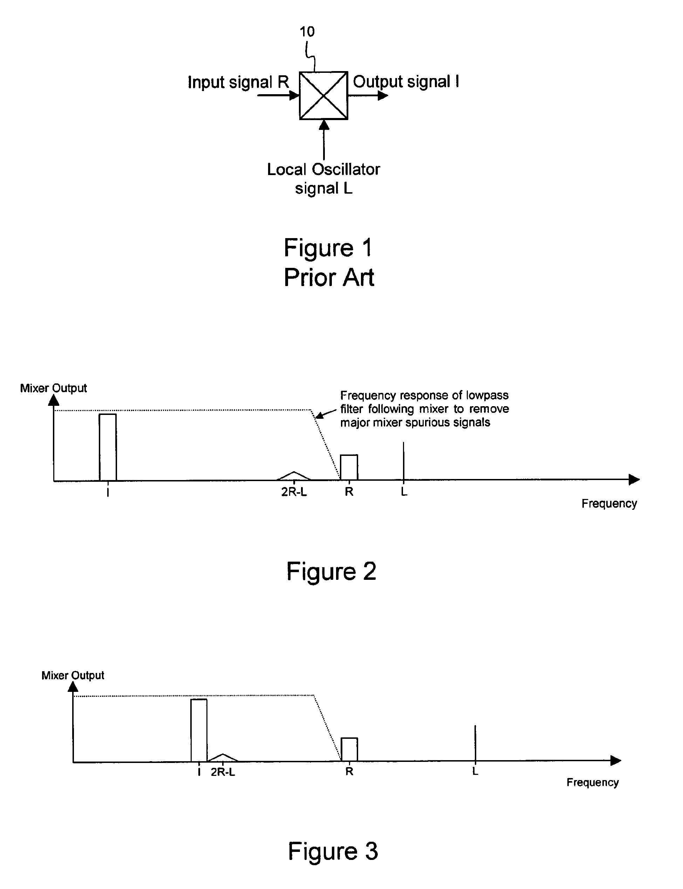

Referring to Figure 1, a known mixer or modulator 10 frequently used to frequency-shift an input analogue or digital signal of frequency R, uses a local oscillator signal of frequency L to produce an output signal of frequency I, as shown schematically in Figure 1.

The mixer 10 potentially generates the following frequencies:

$$I = mR + nL$$

where m and n are negative or positive integers or zero.

There are strong outputs produced at frequencies (R + L) and (-R + L), where in the former case m=1 and n=1 and in the latter case m=-1 and n=1. Normally, only one of these outputs is desired. The unwanted output is usually at a sufficiently different frequency from the wanted output, that the unwanted output can be substantially removed with a filter.

Signals generated for other values of m and n are usually unwanted signals and are termed "mixer spurs". They are generally much lower in level than the wanted output, and are often at sufficiently different frequencies from the wanted frequency R±L that they can again be removed by filtering. Sometimes, however, some of the mixer spurs are too close to the desired signal to be removed by filtering, or even if filtering can remove them, the required filter may be complex, expensive and sizable to implement.

One such mixer spur that in some circumstances can cause problems is a spur at mixer output frequency I = 2R - L, i.e. for which m=2 and n=1.

Problems that this mixer spur can cause are exemplified by a case of a down-converter that takes in a high frequency RF signal and mixes it down to a lower frequency. For this case, it may be assumed that R is a relatively narrowband signal, compared with its centre frequency, and its centre frequency is fixed, or it moves by only small amounts compared with its centre frequency.

Figures 2, 3 and 4 show significant mixer spurs for different local oscillator frequencies L. From these Figures, it can be seen that for three different settings of frequency L, the spurious output signals of frequencies R (for which m=1 and n=0) and L (for which m=0 and n=1) are removed by a lowpass filter that follows the mixer output. The spurious signal of frequency (2R - L) is not, however, removed by this filter. It can be seen that as the local oscillator frequency L increases (to generate increasing wanted output frequencies I) the spur frequency at (2R - L) decreases. When the local oscillator is set to generate an output frequency I close to R/2, the spur (2R - L) is very close or overlapping with the output frequency (L - R), so, as shown in Figures 2-4, the spur cannot be removed by low-pass filtering used to remove major mixer spurious signals. Even if it is not too close to remove by filtering, a tuneable filter or a switched bank of different fixed filters would be required to filter the spur out. Such filtering adds complexity, expense and size to a system, and as noted, cannot reject the spur when it is very close to, or overlapping, the wanted mixer output signal, as shown in Figure 3.

As shown in Figures 2-4, the (2R - L) frequency mixer spur normally has a level much lower than the wanted output I. One way to reduce the spur would be to reduce the input level applied to the mixer. It is known that lowering the input signal level at frequency R by X dB generally lowers the spur by 2X dB, which provides a reduction of the spur relative to the wanted signal of X dB. Unfortunately, reducing the input signal level requires more amplification following the mixer to restore the signal level to a given level, so the signal to noise ratio (SNR) of the output signal degrades by X dB. There is therefore a trade-off between spur level and SNR when altering the mixer input level.

To reduce the spur level relative to the wanted signal level without impairing the SNR, a mixer with lower distortion may be supplied. However, this generally is more expensive. It also generally takes more power for an active mixer or higher local oscillator level for a passive mixer. Such mixers increase cost, circuit size and power consumption.

There is therefore a requirement to reduce a level of the mixer spur without using a lower distortion mixer, and without reducing the output SNR.

It is an object of the present invention at least to ameliorate the aforesaid disadvantages in the prior art.

According to the invention there is provided a pre-distortion stage arranged to cancel a harmonic or intermodulation signal produced from an input signal, the pre-distortion stage comprising non-amplifying components comprising in-phase harmonic generator network means arranged to receive the input signal and in-quadrature harmonic generator network means arranged to receive the input signal, outputs of the in-phase and in-quadrature harmonic generation network means being combined to produce a further harmonic signal of the input signal of a same amplitude and frequency as, but 180 deg. out of phase with, the harmonic or intermodulation signal produced from the input signal, so as to cancel the harmonic or intermodulation signal.

Preferably, at least one of the in-phase harmonic generator means and the in-quadrature harmonic generator means comprises an input for a scaling signal arranged to scale and/or invert an amount of distortion produced by the in-phase harmonic generator means and the in-quadrature harmonic generator means and thereby affect phase and amplitude of the further harmonic signal to match the harmonic or intermodulation signal to be cancelled.

Conveniently, the pre-distortion stage further comprises phase-shift network means arranged such that the outputs of the in-phase and in-quadrature harmonic generation network means are combined with a phase difference of substantially 90°.

Conveniently, the phase-shift network means comprises transmission line means.

Advantageously, at least one of the in-phase harmonic generator means and the in-quadrature harmonic generator means comprises a circuit with non-linear devices.

Conveniently, the circuit with non-linear devices is a diode circuit.

Conveniently, the diode circuit comprises a first path comprising first variable resistor means is series with first fixed resistor means and a second path in parallel with the first path comprising second variable resistor means in series with second fixed resistor means and a diode bridging the first path and the second path between a first point on the first path between the first variable resistor means and the first fixed resistor means and a second point on the second path between the second variable resistor means and the second fixed resistor means.

Optionally, the diode circuit comprises resistor means in series with a first path comprising a first capacitor is series with a first diode and with a second path in parallel with the first path comprising a second capacitor in series with a second diode to form two anti-parallel diodes.

Advantageously, the pre-distortion stage is arranged to cancel a second harmonic signal.

Advantageously, the pre-distortion stage is arranged to suppress third-order intermodulation distortion generated in the harmonic generator network means by impedance mismatching at the further harmonic frequency.

Conveniently, the pre-distortion stage comprises compensation means arranged to compensate the in-phase and in-quadrature scaling settings dependent on at least one of a time period since calibration, to compensate for drift, and ambient conditions.

Advantageously, the pre-distortion stage comprises feedback means to adjust at least one of the in-phase and in-quadrature scaling settings to maximise cancellation of the harmonic or intermodulation signal.

Advantageously, the pre-distortion stage is arranged to cancel a spur frequency signal produced by a mixer from the input signal and arranged to produce the further harmonic signal of the input signal for input with the input signal to the mixer for mixing with a local oscillator signal of the mixer to produce a mixed signal of a same amplitude and frequency as, but 180 deg. out of phase with, the spur frequency harmonic generated from the input signal and the local oscillator signal, so as to cancel the spur frequency harmonic signal.

Conveniently, the pre-distortion stage comprises a memory arranged to store in-phase and in-quadrature calibration scaling settings for at least one local oscillator frequency.

According to a second aspect of the invention there is provided a method of cancelling a harmonic or intermodulation distortion signal generated from an input signal, comprising: generating an in-phase distortion signal of the input signal; generating an in-quadrature distortion signal of the input signal; summing the in-phase distortion signal and the in-quadrature distortion signal to form a summed distortion signal to produce a pre-distortion signal of a same amplitude and frequency as the harmonic or intermodulation signal to be cancelled, but 180 deg. out of phase therewith; and cancelling the harmonic or intermodulation signal with the pre-distortion signal.

Preferably, the method further comprises providing a scaling signal arranged to scale and/or invert an amount of distortion produced in generating at least one of the in-phase distortion signal and the in-quadrature distortion signal and thereby to affect phase and amplitude of the pre-distortion signal to match the harmonic or intermodulation signal to be cancelled.

Advantageously, the method further comprises using phase shift circuit means to produce the in-quadrature distortion signal.

Conveniently, using phase shift circuit means comprises using transmission line means.

Advantageously, at least one of generating the in-phase harmonic signal and the in-quadrature harmonic signal comprises using a circuit comprising non-linear devices.

Conveniently, using a circuit with non-linear devices comprises using a diode circuit.

Conveniently, using a diode circuit comprises using a first path comprising first variable resistor means is series with first fixed resistor means and a second path in parallel with the first path comprising second variable resistor means in series with second fixed resistor means and a diode bridging the first path and the second path between a first point on the first path between the first variable resistor means and the first fixed resistor means and a second point on the second path between the second variable resistor means and the second fixed resistor means.

Optionally, using the diode circuit comprises using resistor means in series with a first path comprising a first capacitor is series with a first diode and with a second path in parallel with the first path comprising a second capacitor in series with a second diode to form two anti-parallel diodes.

Advantageously, the method comprises cancelling a second harmonic signal.

Advantageously, the method comprises suppressing third-order intermodulation distortion produced in generating the in-phase harmonic signal and the in-quadrature harmonic signal by impedance mismatching at the summed harmonic signal frequency so as to enhance a level of the harmonic signal relative to the intermodulation distortion.

Conveniently, the method comprises compensating the in-phase and in-quadrature scaling settings dependent on at least one of a time period since calibration, to compensate for drift, and ambient conditions.

Advantageously, the method comprises using feedback to adjust at least one of the in-phase and in-quadrature scaling settings to maximise cancellation of the harmonic or intermodulation signal.

Advantageously, the method comprises cancelling a spur frequency signal produced by a mixer from the input signal, by producing a harmonic signal of the input signal for input with the input signal to the mixer so that the mixer mixes the harmonic signal with a local oscillator signal of the mixer to produce a mixed signal of a same amplitude and frequency as, but 180 deg. out of phase with, the spur frequency harmonic generated from the input signal and the local oscillator signal, and thereby cancelling the spur frequency signal.

Conveniently, the method comprises storing calibration in-phase and in-quadrature scaling settings for at least one local oscillator frequency and subsequently using the stored scaling settings.

The invention will now be described, by way of example, with reference to the accompanying drawings in which:

Figure 1 is a schematic diagram of a known mixer;

Figure 2 is a plot of known mixer output with a local oscillator (LO) set to produce a relatively low output frequency I;

Figure 3: is a plot of known mixer output with the LO set to produce an output frequency I that is very close to a (2R-L) spur;

Figure 4 is a plot of known mixer output with the LO set to produce a relatively high output frequency I;

Figure 5 is a schematic diagram of an IQ pre-distortion circuit according to the invention;

Figure 6 is a first example of a second harmonic distortion generator circuit suitable for use with the invention; and

Figure 7 is a second example of a second harmonic distortion generator circuit suitable for use with the invention.

In the Figures, like reference numbers denote like parts.

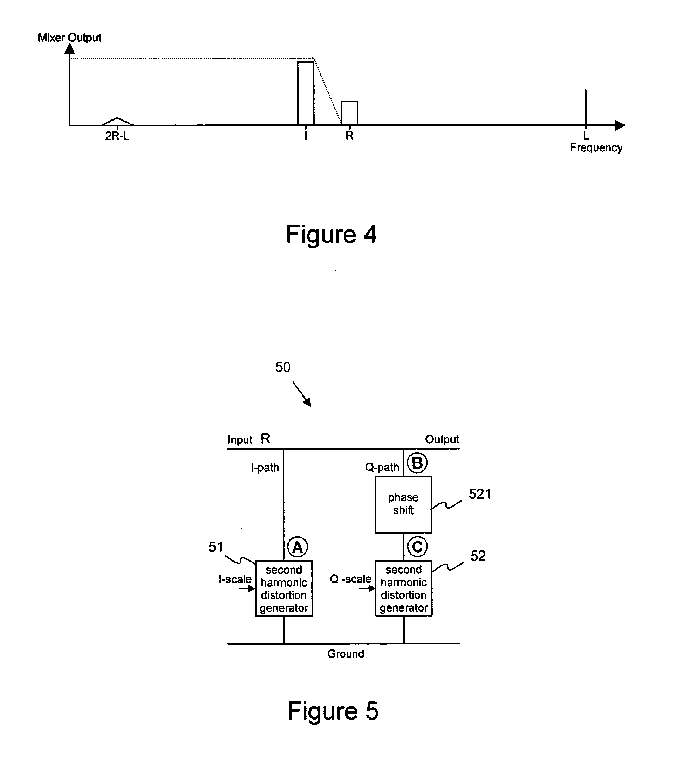

Referring to Figure 5, according to the invention there is provided a mixer pre-distortion stage 50 that does not use active amplifying components. The pre-distortion stage 50 comprises two distortion networks in parallel, a first distortion network 51 to produce in-phase (I) harmonic distortion from an input signal of frequency R and a second distortion network 52 to produce in-quadrature (Q) harmonic distortion from the input signal of frequency R. One of the paths, the Q path as illustrated in Figure 5, although it can be either, includes a phase shifter 521 so that the in-quadrature version of the signal is phase shifted such that the phase of a resultant second harmonic signal of frequency 2R signal relative to the phase of the R signal at point B, at a signal input to the phase shift network 521, is 90° different from the phase of the 2R signal relative to the R signal at point A, at a signal input to the first distortion network 51. The phase difference can in fact be an odd multiple of 90°, although this generally results in lower cancellation bandwidth of the spurious signal. Fully adjustable amplitude and phase of the 2R signal is still possible if the phase shift between the I- and Q-paths is not exactly 90°; full adjustability is only impossible if this phase shift is an even multiple of 90°. However, adjustment is easier if the phase shift is close to an odd multiple of 90°.

The pre-distortion network 50 according to the invention works by pre-distorting the input R to a mixer, generating a second harmonic 2R. This mixes in the mixer with a local oscillator frequency L to produce a signal 2R-L which is arranged to have a same amplitude but is 180° out of phase with the spur, so that it cancels out the spurious signal at an output of the mixer.

By the term mixer spur, it will be understood that the spurs are of a form described in the equation I = mR + nL above. However, the method and apparatus of the invention will also suppress distortion already present in an input signal at a point where the invention is applied.

Conveniently, the invention can be successfully applied if there are multiple sources of distortion in a circuit to which the invention is applied. In addition, some of the distortion sources can be before, and some of the distortion sources can be after, a point at which the invention is applied in a circuit.

For good cancellation, the second harmonic at frequency 2R generated by the pre-distortion circuit must be adjustable in amplitude and phase so that when the second harmonic arrives in the mixer and mixes with the local oscillator signal, the resultant 2R-L signal cancels the spur at 2R-L. One aspect of the invention is a pre-distortion technique and suggested circuits that allow the 2R signal to have adjustable phase and amplitude. This is implemented by having IQ adjustments.

It is known that adjustable amplitude and phase of a narrowband signal can be achieved by having two separate signals that are in-phase (I) and in-quadrature (Q) versions of that signal, and by independently adjusting the amplitudes of each signal (also allowing the signals to be inverted) and then summing these two signals together, the result is the same narrowband signal that can be arbitrarily adjusted in amplitude and phase.

The I and Q distortion generators 51, 52 have scaling signals, 1-scale and Q-scale, respectively, as shown in Figure 5. These scaling signals effectively scale the amount of distortion produced, and if the scaling that produces a maximum distortion is Smax, then the scaling must be variable over the range -Smax to +Smax. If the scale factor is set to a negative value, the scale factor inverts the distortion, changing its phase by 180°. If the scale factor is set to zero, no distortion is generated.

One way to implement the phase shift 521 is with a transmission line. If a length of the transmission line is chosen so that the phase shift between points B, at a signal input to the phase shifter, and point C, between the phase shifter and the second distortion generator 52, for the signal at frequency R is 22.5°, then the phase shift of the second harmonic at frequency 2R generated at point C is double that of the signal at R since it has double the frequency. The 2R distortion generated at point C is therefore phase shifted by 45° compared to the phase of the 2R signal generated at point A, at a signal input to the first distortion generator 51. This 2R distortion at point C is then transmitted back along the transmission line 521 from point C to point B, where the 2R distortion is phase shifted by a further 45°. The total phase shift of the signal at frequency 2R at point B generated by the Q-path is therefore 90°, compared to a phase shift of 0° for the signal at point A generated by the distortion circuit in the I-path. It can therefore be seen that a transmission line of appropriate length (or alternatively some other phase shift network) provides the necessary 90° phase shift required at 2R for IQ operation. An important factor governing phase shift is a difference in phase shifts in the I- and Q-paths, so if an extra equal amount of phase shift is added to both paths, the phase difference between the 2R signals at A and B is still 90°.

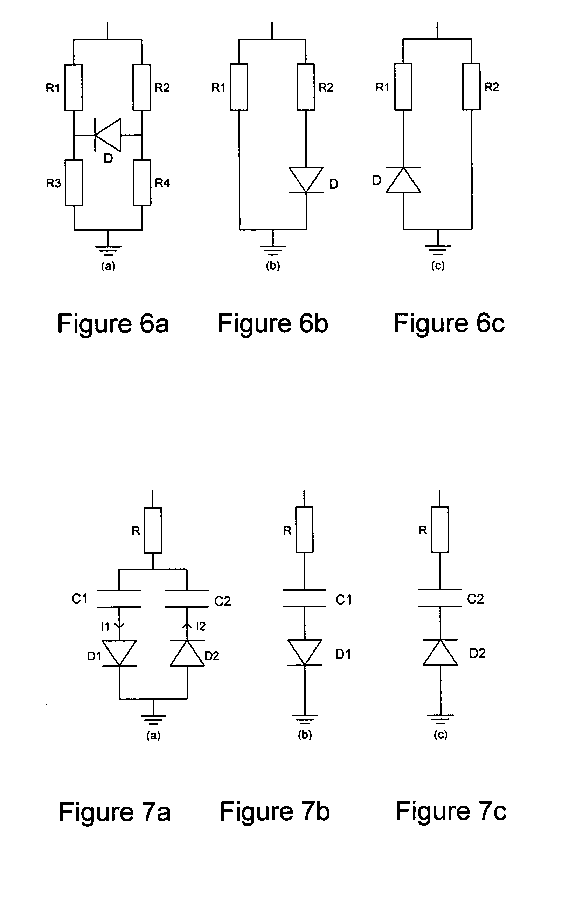

One method of generating second harmonic distortion is to use a diode circuit or any similarly nonlinear device. Figure 6a and Figure 7a show two different circuit possibilities, although there are many others, which can also scale an amount of distortion.

In Figure 6a, resistors R1, R2, R3, R4 are used to change an amplitude of the distortion. To produce sufficient second harmonic distortion, the diode may need to have some DC bias flowing through it, although certain types of diodes may generate enough second harmonic distortion for certain applications without this bias. The bias circuit is not shown in this Figure. R3 and R4 are variable resistors, and R1 and R2 have equal and fixed resistance. Extreme settings of the circuit demonstrate clearly that the amplitude of the distortion can be inverted (i.e. phase shifted by 180°). If R3 is set to very low resistance and R4 is set to very high resistance, the circuit looks substantially like that in Figure 6b. On the other hand, if R3 is set to very high resistance and R4 is set to very low resistance, the circuit looks substantially like that in Figure 6c. It can be seen that the circuits shown in Figures 6b and 6c are identical, except that diodes are reversed in polarity, so the second harmonic distortion produced by the two circuits have the same amplitude but differs in phase by 180° - the distortion is inverted. A mid-setting has R3 and R4 at equal resistance values, which results in no RF voltage across the diode, so no distortion; this is the setting at which the distortion amplitude is zero. It can therefore be seen that a signed amplitude adjustment of the amount of second harmonic distortion can be made with this circuit. By careful choice of the adjustable resistance values R3, R4, the impedance of the distortion circuit can be made constant for all amplitude settings - a useful feature to prevent impedance mismatch problems at certain settings. The variable resistors R3, R4 could be electronically controlled resistors, for example PIN diodes. In this way, the distortion amplitude can be varied electronically rather than mechanically. Note that R1 and R2 could be made the variable resistors instead of, or in addition to, R3 and R4, with the circuit operating in a similar manner.

In Figure 7a, variable DC bias currents through two anti-parallel diodes D1, D2 are set to different values to change an amplitude and sign of the distortion. It is known that an amount of distortion produced by a diode varies with a DC bias current passed through it. The distortion increases with DC bias current up to a certain current, then decreases again as the DC bias current is further increased. One way to make use of this is to set the DC bias current for one diode to vary between a very low value (Imin) and a value (Imax) close to that which produces maximum distortion. The DC bias current for the other diode is made to vary in the opposite sense - from Imax to Imin - so that the sum of the two bias currents is approximately constant. Extreme settings of the circuit demonstrate clearly that the amplitude of the distortion can be inverted, i.e. phase shifted by 180°. If the DC bias current in D1 is I1 which is set to Imax, and that in D2 is I2 which is set to Imin, D1 produces more distortion than D2, so the circuit looks substantially like that in Figure 7b. On the other hand, if I1 is set to Imin, and I2 is set to Imax, D2 produces more distortion than D1, so the circuit looks substantially like that in Figure 7c. It can be seen that the circuits shown in Figures 7b and 7c are identical, except that diodes are in different directions, so the second harmonic distortion produced by the two circuits have the same amplitude but differs in phase by 180° - the distortion is inverted. A mid-setting has D1 and D2 biased with equal DC currents (Imin+Imax)/2, which results in a same amount of second harmonic being generated by each diode, but with opposite phases, so the two distortions cancel; this is the setting at which the distortion amplitude is zero. It can therefore be seen that a signed amplitude adjustment of the amount of second harmonic distortion can be made with this circuit. The impedance of the distortion circuit will also be approximately constant for all amplitude settings - a useful feature to prevent impedance mismatch problems.

It may be desirable to minimise other distortion signals produced by the distortion circuit. Most distortion generation circuits, including those based on one or more diodes, not only generate the required second harmonic, but also other unwanted distortion signals. These include third, fourth and higher harmonics as well as second, third and higher intermodulation signals. Since the level of the 2R-L distortion signal generated by the mixer is usually very low, the IQ pre-distortion circuit only needs to generate a small amount of second harmonic distortion to cancel it. It is known that if a distortion circuit generates a small amount of second harmonic distortion, then the distortion generated at orders higher than second order distortion will generally be much lower, so these are unlikely to be a problem. Also, third and higher harmonics will generally be at much higher frequencies, so can be filtered out. The second-order distortion also produces a low-frequency distortion signal with a frequency range of 0 to B, where B is the bandwidth of the wanted signal centred on R. This unwanted distortion signal is generally much lower in frequency than the wanted signal centred on R so can also be filtered out. The most significant unwanted distortion signal that cannot easily be removed by filtering is third-order intermodulation distortion, which is centred on R with a bandwidth of 3B. One way to decrease its level is to use a more efficient way of channelling the second harmonic distortion generated by the distortion circuit to the output. By doing this, a lower signal level at R needs to be applied to the distortion generation circuit for the same amount of second harmonic as before, so that less third-order intermodulation distortion is generated.

One way to do this is to arrange for the input circuitry seen by the IQ pre-distortion circuitry to have a good impedance match at frequency R, but to appear as an open circuit at frequency 2R so the latter signal is reflected back, increasing the level at the output compared to an input with a good impedance match at frequency 2R. An open circuit is easy to achieve if the input circuitry has a bandpass or lowpass filter that passes the wanted signal but attenuates the second harmonic. This filter will be reflective at 2R, and the transmission line between it and the pre-distortion circuit allows further adjustment to the impedance to make the impedance at 2R seen from the pre-distortion circuit open circuit.

A calibration procedure is preferably provided. The amplitude and phase of the 2R-L mixer spur may well vary with the mixer local oscillator frequency and amplitude, and may well vary with different samples of the mixer that are otherwise identical due to component and manufacturing tolerances. For these reasons, it may be necessary to adjust the I and Q settings with the LO frequency used, and also adjust the setting for each manufactured unit. A calibration procedure can be used during production of each unit, such that the 2R-I spur level is measured, and the I and Q settings are varied substantially to cancel the spur. These settings can be stored in some form of memory such that they can be recalled and applied during normal circuit operation. This calibration procedure can be repeated for different LO frequency settings for the case of a frequency-agile system (such as a terrestrial or cable modulator where the output frequency is tuned over the VHF/UHF spectrum). Calibration at every LO frequency used may not be required. Instead, calibration at certain LO frequencies could be performed, and interpolation or extrapolation of the I and Q settings could be used for frequencies between or beyond the calibration frequencies, respectively.

There is a possibility that the optimum I and Q settings might change with environmental conditions (temperature, humidity, etc) and time (due to drift). Techniques can be used to measure the environmental conditions that the circuit is operating in, and compensate the I and Q settings such that any degradation in cancellation is reduced or eliminated.

An alternative is a feedback technique where the spurious signal is actually measured at the output of the mixer, and feedback is used to adjust the I and Q settings to reduce or eliminate the measured spurious signal.

Although the invention is primarily to reduce or eliminate a 2R-L mixer spur, it could be used to reduce or eliminate other types of mixer spurs (e.g. 3R-L) by changing the I- and Q-path distortion generators used in the circuit such that they generate third rather than second harmonic distortion, and by adjusting the phase shift circuit such that there is now a 90° phase shift between the two paths at 3R rather than 2R. Similarly, third-order intermodulation distortion (centred on R and with bandwidth 3B) could be reduced or eliminated by these means.

The invention can also be used in cases where the distortion does not involve mixer spurs, for example to reduce or eliminate second harmonic, third (or higher) harmonic, or intermodulation distortions. In cases where the signal can have its frequency changed substantially, the phase shift network will not have a 90° phase difference between the distortions generated by the I and Q paths at some frequencies. Distortion can still be eliminated if the phase shift is not exactly 90°. It may, however, be advantageous to adjust the phase shift network (electronically, for example) depending on the frequency of the signal applied to it, so that the phase shift is substantially 90° between the distortions of the I- and Q-path irrespective of the frequency of operation.

This invention provides a means whereby the "2R - L" spurious output of a mixer or modulator is reduced, while at least maintaining the output signal-to-noise ratio (SNR) of the mixer. In some circumstances, the output SNR can be increased by increasing the input level to the mixer. Normally, this would also increase the "2R - L" spur, but when applied in conjunction with this invention, this spur can be reduced to an arbitrarily low level. The method of the invention can be extended in scope to deal with specific spurious components other than 2R-L or, in combination, to deal with several simultaneously.

The invention also provides a simple circuit that does not require amplifying components, which can be used to generate a second harmonic with adjustable amplitude and phase.

The invention can be applied specifically to analogue and digital television RF frequency up- or down-converter transmission equipment for terrestrial and cable broadcasting but is not limited to this application.

In general, the method can be applied to up- or down-conversion from a high frequency signal of relatively fixed frequency to a lower frequency signal using a mixer and a local oscillator. If the local oscillator is made tuneable, the output frequency can be varied, and the technique is still applicable.

This invention therefore reduces a level of a mixer spur without needing to use a lower distortion mixer, and without reducing the output SNR. Indeed the technique used removes the constraint on signal levels and thus allows improvements in the SNR.

**Claims**

1. A pre-distortion stage (50) arranged to cancel a harmonic or intermodulation signal produced from an input signal, the pre-distortion stage comprising non-amplifying components comprising in-phase harmonic generator network means (51) arranged to receive the input signal and in-quadrature harmonic generator network means (52) arranged to receive the input signal, outputs of the in-phase and in-quadrature harmonic generation network means being combined to produce a further harmonic signal of the input signal of a same amplitude and frequency as, but 180 deg. out of phase with, the harmonic or intermodulation signal produced from the input signal, so as to cancel the harmonic or intermodulation signal.

2. A pre-distortion stage as claimed in claim 1, wherein at least one of the in-phase harmonic generator means (51) and the in-quadrature harmonic generator means (52) comprises an input for a scaling signal arranged to scale and/or invert an amount of distortion produced by the in-phase harmonic generator means and the in-quadrature harmonic generator means and thereby affect phase and amplitude of the further harmonic signal to match the harmonic or intermodulation signal to be cancelled.

3. A pre-distortion stage as claimed in claims 1 or 2, further comprising phase-shift network means (521) arranged such that the outputs of the in-phase and in-quadrature harmonic generation network means are combined with a phase difference of substantially 90°.

4. A pre-distortion stage as claimed in claim 3, wherein the phase-shift network means comprises transmission line means.

5. A pre-distortion stage as claimed in any of the preceding claims, wherein at least one of the in-phase harmonic generator means and the in-quadrature harmonic generator means comprises a circuit with non-linear devices.

6. A pre-distortion stage as claimed in claim 5, wherein the circuit with non-linear devices is a diode circuit.

7. A pre-distortion stage as claimed in claim 6, wherein the diode circuit comprises a first path comprising first variable resistor means (R1) is series with first fixed resistor means (R3) and a second path in parallel with the first path comprising second variable resistor means (R2) in series with second fixed resistor means (R4) and a diode (D) bridging the first path and the second path between a first point on the first path between the first variable resistor means and the first fixed resistor means and a second point on the second path between the second variable resistor means and the second fixed resistor means.

8. A pre-distortion stage as claimed in claim 6, wherein the diode circuit comprises resistor means (R) in series with a first path comprising a first capacitor (C1) is series with a first diode (D1) and with a second path in parallel with the first path comprising a second capacitor (C2) in series with a second diode (D2) to form two anti-parallel diodes.

9. A pre-distortion stage as claimed in any of the preceding claims arranged to cancel a second harmonic signal.

10. A pre-distortion stage as claimed in any of the preceding claims arranged to suppress third-order intermodulation distortion generated in the harmonic generator network means by impedance mismatching at the further harmonic frequency.

11. A pre-distortion stage as claimed in any of claims 2 to 10, comprising compensation means arranged to compensate the in-phase and in-quadrature scaling settings dependent on at least one of a time period since calibration, to compensate for drift, and ambient conditions.

12. A pre-distortion stage as claimed in any of claims 2 to 11, comprising feedback means to adjust at least one of the in-phase and in-quadrature scaling settings to maximise cancellation of the harmonic or intermodulation signal.

13. A pre-distortion stage as claimed in any of the preceding claims arranged to cancel a spur frequency signal produced by a mixer from the input signal and arranged to produce the further harmonic signal of the input signal for input with the input signal to the mixer for mixing with a local oscillator signal of the mixer to produce a mixed signal of a same amplitude and frequency as, but 180 deg. out of phase with, the spur frequency harmonic generated from the input signal and the local oscillator signal, so as to cancel the spur frequency harmonic signal.

14. A pre-distortion stage as claimed in claim 13, comprising a memory arranged to store in-phase and in-quadrature calibration scaling settings for at least one local oscillator frequency.

15. A method of cancelling a harmonic or intermodulation distortion signal generated from an input signal, comprising:

    a. generating an in-phase distortion signal of the input signal;
    b. generating an in-quadrature distortion signal of the input signal;
    c. summing the in-phase distortion signal and the in-quadrature distortion signal to form a summed distortion signal to produce a pre-distortion signal of a same amplitude and frequency as the harmonic or intermodulation signal to be cancelled, but 180 deg. out of phase therewith; and
    d. cancelling the harmonic or intermodulation signal with the pre-distortion signal.

16. A method as claimed in claim 15 comprising providing a scaling signal arranged to scale and/or invert an amount of distortion produced in generating at least one of the in-phase distortion signal and the in-quadrature distortion signal and thereby to affect phase and amplitude of the pre-distortion signal to match the harmonic or intermodulation signal to be cancelled.

17. A method as claimed in claims 15 or 16, further comprising using phase shift circuit means (521) to produce the in-quadrature distortion signal.

18. A method as claimed in claim 17, wherein using phase shift circuit means comprises using transmission line means.

19. A method as claimed in any of claims 15 to 18, wherein at least one of generating the in-phase harmonic signal and the in-quadrature harmonic signal comprises using a circuit comprising non-linear devices.

20. A method as claimed in claim 19 wherein using a circuit comprising non-linear devices comprises using a diode circuit.

21. A method as claimed in claim 20, wherein using a diode circuit comprises using a first path comprising first variable resistor means (R1) is series with first fixed resistor means (R3) and a second path in parallel with the first path comprising second variable resistor means (R2) in series with second fixed resistor means (R4) and a diode (D) bridging the first path and the second path between a first point on the first path between the first variable resistor means and the first fixed resistor means and a second point on the second path between the second variable resistor means and the second fixed resistor means.

22. A method as claimed in claim 20, wherein using the diode circuit comprises using resistor means (R) in series with a first path comprising a first capacitor (C1) is series with a first diode (D1) and with a second path in parallel with the first path comprising a second capacitor (C2) in series with a second diode (D2) to form two anti-parallel diodes.

23. A method as claimed in any of claims 15 to 22, comprising cancelling a second harmonic signal.

24. A method as claimed in any of claims 15 to 23, comprising suppressing third-order intermodulation distortion produced in generating the in-phase harmonic signal and the in-quadrature harmonic signal by impedance mismatching at the summed harmonic signal frequency so as to enhance a level of the harmonic signal relative to the intermodulation distortion.

25. A method as claimed in any of claims 15 to 24, comprising compensating the in-phase and in-quadrature scaling settings dependent on at least one of a time period since calibration, to compensate for drift, and ambient conditions.

**26.** A method as claimed in any of claims 15 to 25, comprising using feedback to adjust at least one of the in-phase and in-quadrature scaling settings to maximise cancellation of the harmonic or intermodulation signal.

**27.** A method as claimed in any of claims 15 to 26, comprising cancelling a spur frequency signal produced by a mixer from the input signal, by producing a harmonic signal of the input signal for input with the input signal to the mixer so that the mixer mixes the harmonic signal with a local oscillator signal of the mixer to produce a mixed signal of a same amplitude and frequency as, but 180 deg. out of phase with, the spur frequency harmonic generated from the input signal and the local oscillator signal, and thereby cancelling the spur frequency signal.

**28.** A method as claimed in claim 27 comprising storing calibration in-phase and in-quadrature scaling settings for at least one local oscillator frequency and subsequently using the stored scaling settings.

10

Input signal R   →   ⊠   →   Output signal I

↑

Local Oscillator
signal L

# Figure 1
# Prior Art

Mixer Output

Frequency response of lowpass
filter following mixer to remove
major mixer spurious signals

I          2R-L     R     L

Frequency

# Figure 2

Mixer Output

I  2R-L                R            L

Frequency

# Figure 3

Figure 4

Figure 5

Figure 6a   Figure 6b   Figure 6c

Figure 7a   Figure 7b   Figure 7c

European Patent
Office

**EUROPEAN SEARCH REPORT**

Application Number

EP 07 25 3981

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 838 195 A (SZMURLO THOMAS E [US] ET AL) 17 November 1998 (1998-11-17) | 1,2,9, 12,15, 16,23,26 | INV. H03C1/06 H03D1/06 |
| Y | * column 3, line 47 - column 4, line 18; figures 2,6 * | 3-8,10, 11,13, 14, 17-22, 24,25, 27,28 | |
| | * column 4, line 46 - line 59 * ----- | | |
| A | EP 0 926 847 A (PIRELLI CAVI E SISTEMI SPA [IT]) 30 June 1999 (1999-06-30) | 1,2,9, 12,15, 16,23,26 | |
| Y | * paragraph [0038] - paragraph [0082]; figures 1-3 * | 3-8,10, 11,13, 14, 17-22, 24,25, 27,28 | |
| | ----- | | TECHNICAL FIELDS SEARCHED (IPC) |
| A | US 4 291 277 A (DAVIS ROBERT C ET AL) 22 September 1981 (1981-09-22) * figure 4 * ----- | 1-28 | H03C H03D H03F |
| A | EP 0 475 376 A (GEN INSTRUMENT CORP [US]) 18 March 1992 (1992-03-18) * column 5, line 14 - column 6, line 6; figures 3,4A-4C * ----- | 1-28 | |
| A | US 5 172 068 A (CHILDS RICHARD B [US]) 15 December 1992 (1992-12-15) * column 2, line 17 - column 6, line 63; figures 1-5 * ----- | 1-28 | |

The present search report has been drawn up for all claims

| Place of search | Date of completion of the search | Examiner |
|---|---|---|
| Munich | 1 February 2008 | Ratajski, André |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 07 25 3981

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2008

| Patent document cited in search report | | Publication date | Patent family member(s) | | Publication date |
|---|---|---|---|---|---|
| US 5838195 | A | 17-11-1998 | NONE | | |
| EP 0926847 | A | 30-06-1999 | NONE | | |
| US 4291277 | A | 22-09-1981 | NONE | | |
| EP 0475376 | A | 18-03-1992 | CA | 2051227 A1 | 13-03-1992 |
| | | | DE | 69125075 D1 | 17-04-1997 |
| | | | DE | 69125075 T2 | 11-09-1997 |
| | | | HK | 1008408 A1 | 07-05-1999 |
| | | | JP | 6342178 A | 13-12-1994 |
| | | | MX | 9101051 A1 | 04-05-1992 |
| | | | NO | 913576 A | 13-03-1992 |
| | | | US | 5210633 A | 11-05-1993 |
| US 5172068 | A | 15-12-1992 | NONE | | |

EPO FORM P0459

For more details about this annex : see Official Journal of the European Patent Office, No. 12/82